# EUROPEAN PATENT APPLICATION

(11) **EP 4 670 998 A1**
(43) Date of publication of application: **31.12.2025**
(21) Application number: 23923710.0
(22) Date of filing: 16.10.2023
(51) Int. Cl.: B44C 5/04, H05K 5/02

(54) **DECORATING PART, ELECTRONIC DEVICE, AND PREPARATION METHOD FOR DECORATING PART**

(30) Priority: 24.02.2023 CN 202310212309
(71) Applicant: BYD Company Limited, Shenzhen, Guangdong 518118 (CN)
(72) Inventor: YUAN, Sun, Shenzhen, Guangdong 518118 (CN); ZHAO, Lihong, Shenzhen, Guangdong 518118 (CN); LUO, Wenhai, Shenzhen, Guangdong 518118 (CN); DUAN, Feifei, Shenzhen, Guangdong 518118 (CN); ZHAO, Fei, Shenzhen, Guangdong 518118 (CN)
(74) Representative: Mathys & Squire
(86) International application number: PCT/CN2023/124734
(87) International publication number: WO 2024/174545

(57) **Abstract**

A decorative member, an electronic device, and a preparation method for the decorative member. A decorative member (10) comprises a base body (100) and a grating laver (200), which is arranged on the base body (100), wherein the grating layer (200) comprises a plurality of first texture regions (210), at least some of the first texture regions (210) being formed by means of superimposing and compounding M grating patterns (300) according to a preset relationship; each grating pattern (300) comprises a plurality of grating regions (310); and at least one grating region (310) in an (N+l)th grating pattern (300) and at least one grating region (310) in an Nth grating pattern (300) are superimposed, and a grating angle a of the grating region (310) in the Nth grating pattern (300), a grating angle b of the grating region (310) in the (N+l)th grating pattern (300), and a grating angle c of a superimposed region (310c) of the grating region (310) in the (N+l)th grating pattern (300) and the grating region (310) in the Nth grating pattern (300) satisfy a preset relational expression: c=X*a+Y*b.

## Description

This application claims priority to Chinese Patent Application No. 202310212309.6, filed with the China National Intellectual Property Administration on February 24, 2023 and entitled "DECORATIVE MEMBER, ELECTRONIC DEVICE, AND PREPARATION METHOD FOR DECORATIVE MEMBER", which is incorporated herein by reference in its entirety.

### TECHNICAL FIELD

This application relates to the field of optical technologies, and in particular to a decorative member, an electronic device, and a preparation method for the decorative member.

### BACKGROUND

With the progress of science and technology and reduction of production costs, the micro-nano structure texture technology is being increasingly used in appearance decoration of electronic devices (such as mobile phones, tablets, and watches). An existing decorative member has a monotonous light and shadow effect and lacks spatial hierarchy and three-dimensionality.

### SUMMARY

An embodiment of this application provides a decorative member, an electronic device, and a preparation method for the decorative member, so that a light and shadow effect of the decorative member exhibits spatial hierarchy and three-dimensionality.

In a first aspect, this application provides a decorative member. The decorative member includes a base and a grating layer arranged on the base. The grating layer includes a plurality of first texture regions, and at least a part of the plurality of first texture regions are formed by superimposing and compounding M grating patterns based on a preset relationship. Each grating pattern includes a plurality of grating regions that are spaced apart. Grating angles of the grating regions on at least two grating patterns in the M grating patterns are different.

At least one grating region in an (N+1)^{th} grating pattern and at least one grating region in an N^{th} grating pattern are superimposed, and a grating angle 'a' of the grating region in the N^{th} grating pattern, a grating angle 'b' of the grating region in the (N+1)^{th} grating pattern, and a grating angle 'c' of a superimposed region of the grating region in the (N+1)^{th} grating pattern and the grating region in the N^{th} grating pattern satisfy a preset relational expression: c=X*a+Y*b. N and M are integers, and 1≤N≤M-2. X is denoted as a first weight, and Y is denoted as a second weight. When the grating angle a of the grating region in the N^{th} grating pattern is different from the grating angle b of the grating region in the (N+1)^{th} grating pattern, the first weight and the second weight satisfy: 0.8≤X+Y≤1.

In a second aspect, this application provides an electronic device. The electronic device includes the decorative member described above.

In a third aspect, this application provides a preparation method for the decorative member. The preparation method includes:
obtaining a base;
superimposing and compounding M grating patterns based on a preset relationship to obtain a grating layer, wherein
each grating pattern includes a plurality of grating regions, and grating angles of the grating regions on at least two grating patterns in the M grating patterns are different; at least one grating region in the (N+1)^{th} grating pattern and at least one grating region in an N^{th} grating pattern are superimposed, and a grating angle a of the grating region in the N^{th} grating pattern, a grating angle b of the grating region in the (N+1)^{th} grating pattern, and a grating angle c of a superimposed region of the grating region in the (N+1)^{th} grating pattern and the grating region in the N^{th} grating pattern satisfy a preset relational expression: c=X*a+Y*b; N and M are integers, and 1≤N≤M-2; X is denoted as a first weight, and Y is denoted as a second weight; and when the grating angle a of the grating region in the N^{th} grating pattern is different from the grating angle b of the grating region in the (N+1)^{th} grating pattern, the first weight and the second weight satisfy: 0.8≤X+Y≤1; and
forming the grating layer on the base to obtain the decorative member.

According to a decorative member, an electronic device, and a preparation method for the decorative member according to this application, a grating layer is arranged on the base. The grating layer includes a plurality of first texture regions. At least a part of the plurality of first texture regions are formed by superimposing and compounding M grating patterns based on a preset relationship. The decorative member has different light and shadow effects at different positions, so that a light and shadow effect of the decorative member exhibits better spatial hierarchy and three-dimensionality.

### BRIEF DESCRIPTION OF DRAWINGS

To describe the technical solutions in embodiments of this application more clearly, the following briefly describes the drawings required in the embodiments. Apparently, the drawings in the following description show merely some embodiments of this application, and a person of ordinary skill in the art may derive other drawings from these drawings without creative efforts.
FIG. 1 is a side view of a decorative member according to an embodiment of this application;
FIG. 2 is a light and shadow effect drawing of a decorative member according to an embodiment of this application;
FIG. 3 is a structure diagram of a local region of a grating layer in a decorative member according to an embodiment of this application;
FIG. 4 is a structure diagram of an N^{th} grating pattern in a decorative member according to an embodiment of this application;
FIG. 5 is a structure diagram of an (N+1)^{th} grating pattern in a decorative member according to an embodiment of this application;
FIG. 6 is a structure diagram of an (N+1)^{th} grating pattern and an N^{th} grating pattern superimposed and compounded based on a preset relationship in a decorative member according to an embodiment of this application;
FIG. 7 is a partial enlarged view at a position of E in FIG. 6;
FIG. 8 is a cross-sectional view of FIG. 7 along an F-F line;
FIG. 9 is diagram showing a light and shadow effect of a decorative member according to some embodiments of this application;
FIG. 10 is a structure diagram of a decorative member according to some embodiments of this application;
FIG. 11 is a flowchart of a preparation method for a decorative member according to some embodiments of this application; and
FIG. 12 is a diagram of an electronic device according to some embodiments of this application.

Reference numerals: 10: decorative member; 100: base; 101: texture surface; 200: grating layer; 210: first texture region; 220: second texture region; 300: grating pattern; 310: grating region; 310a: first grating region; 310b: second grating region; 310c: superimposed region; 312: grating structure; D: grating width; H: grating height; X: first weight; Y: second weight; 1000: electronic device; and 1002: device body.

This application is further described with reference to the drawings in the following specific embodiments.

### DESCRIPTION OF EMBODIMENTS

The following clearly and completely describes the technical solutions in embodiments of this application with reference to the drawings in embodiments of this application. It will be appreciated that, the described embodiments are merely a part rather than all of embodiments of this application. All other embodiments obtained by those skilled in the art based on embodiments of this application without creative efforts shall fall within the protection scope of this application.

An "embodiment" or "implementation" mentioned throughout this specification means that specified features, structures, or characteristics described in combination with the example or the embodiment may be included in at least one embodiment of this application. The appearance of the term in various places in this specification does not necessarily mean a same embodiment, nor an independent or alternative embodiment that is mutually exclusive from other embodiments. It is explicitly and implicitly understood by those skilled in the art that the embodiments described herein may be combined with other embodiments.

It will be noted that the terms in this specification, claims and drawings of this application are for the purpose of describing specific embodiments only, and are not intended to limit this application. In this specification, claims and drawings of this application, the terms such as "first" and "second" are intended to distinguish between different objects but not indicate a particular order. The term "and/or" used in this specification of this application and the appended claims means any combination and all possible combinations of one or more of the associated listed items, and includes such combinations.

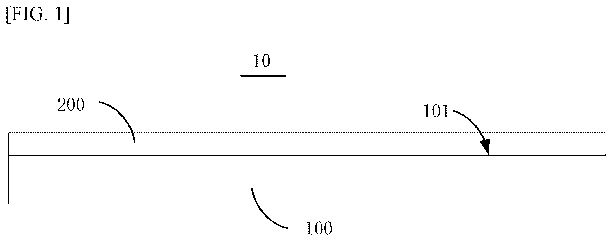

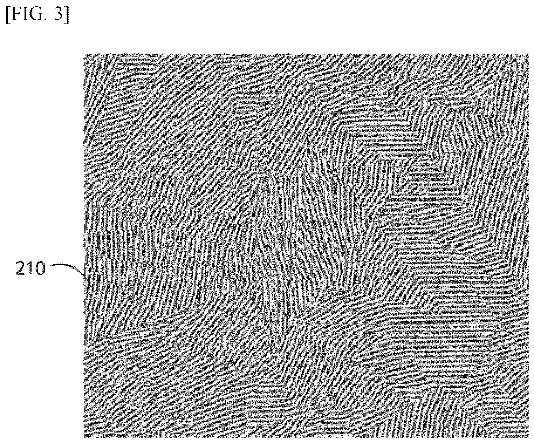

Referring to FIG. 1, FIG. 2, FIG. 3 and FIG. 7, this application provides a decorative member 10. The decorative member 10 includes a base 100 and a grating layer 200 arranged on the base 100. The grating layer 200 includes a plurality of first texture regions 210. At least a part of the plurality of first texture regions 210 are formed by superimposing and compounding M grating patterns 300 based on a preset relationship, wherein each grating pattern 300 includes a plurality of grating regions 310 that are spaced apart. Grating angles of the grating regions 310 on at least two grating patterns 300 in the M grating patterns 300 are different.

At least one grating region 310 in an (N+1)^{th} grating pattern 300 and at least one grating region 310 in an N^{th} grating pattern 300 are superimposed, and a grating angle a of the grating region 310 in the N^{th} grating pattern 300, a grating angle b of the grating region 310 in the (N+1)^{th} grating pattern 300, and a grating angle c of a superimposed region 310c of the grating region 310 in the (N+1)^{th} grating pattern 300 and the grating region 310 in the N^{th} grating pattern 300 satisfy a preset relational expression: c=X*a+Y*b, wherein N and M are integers, and 1≤N≤M-2. X is denoted as a first weight, and Y is denoted as a second weight. When the grating angle a of the grating region 310 in the N^{th} grating pattern 300 is different from the grating angle b of the grating region 310 in the (N+1)^{th} grating pattern 300, the first weight and the second weight satisfy: 0.8≤X+Y≤1. In some embodiments, a sum of the first weight and the second weight may be 0.8, 0.85, 0.9, 0.95, 1, or the like.

In the decorative member 10 of this application, a grating layer 200 is arranged on the base 100. The grating layer 200 includes a plurality of first texture regions 210. At least a part of the plurality of first texture regions 210 are formed by superimposing and compounding M grating patterns 300 based on a preset relationship. The decorative member 10 has different light and shadow effects at different positions, so that the light and shadow effect of the decorative member 10 exhibits better spatial hierarchy and three-dimensionality. For example, a number M of the grating patterns 300 may be 5 to 15, so that the light and shadow effect of the decorative member 10 exhibits stronger spatial hierarchy, and the light and shadow effect of the decorative member 10 is clearer, brighter and tidier. In some embodiments, a number M of the grating patterns 300 may be 8 to 10. In some embodiments, a number M of the grating patterns 300 may be 2, 3, 4, 5, 6, 7, 8, 9, 10, 11, 12, 13, 14, 15, 20, or the like. A specific number M of the grating patterns 300 may be specifically set according to actual needs of the decorative member 10, and is not specifically limited in this application.

For example, in this embodiment, the preset relationship may be that M grating patterns 300 are sequentially superimposed and compounded. For example, the second grating pattern 300 is superimposed on the first grating pattern 300, and the third grating pattern 300 is superimposed on a compounded grating pattern formed by superimposing and compounding the second grating pattern 300 and the first grating pattern 300, until the M^{th} grating pattern 300 is superimposed on the (M-1)^{th} grating pattern 300. In another embodiment, for example, the second grating pattern 300 is superimposed on the first grating pattern 300, and the third grating pattern 300 is superimposed on a compounded grating pattern formed by superimposing and compounding the second grating pattern 300 and the first grating pattern 300, until the M^{th} grating pattern 300 is superimposed on a compounded grating pattern formed by superimposing and compounding the (M-2)^{th} grating pattern 300 and the (M-1)^{th} grating pattern 300. In this way, the M grating patterns 300 are sequentially superimposed and compounded to form the grating layer 200. In some embodiments, the preset relationship may be further that the M grating patterns 300 include a plurality of pattern modules. At least one pattern module of the pattern modules includes at least two grating patterns 300. After the grating patterns 300 in the pattern module are sequentially superimposed and compounded, the pattern modules are sequentially superimposed and compounded. For example, when M is 7, seven grating patterns 300 may include a first pattern module, a second pattern module and a third pattern module. The first pattern module includes one grating pattern 300. The second pattern module includes two grating patterns 300. The third pattern module includes four grating patterns 300. After two grating patterns 300 in the second pattern module are sequentially superimposed and compounded and four grating patterns 300 in the third pattern module are sequentially superimposed and compounded, the first pattern module, the second pattern module and the third pattern module are sequentially superimposed and compounded to form the grating layer 200.

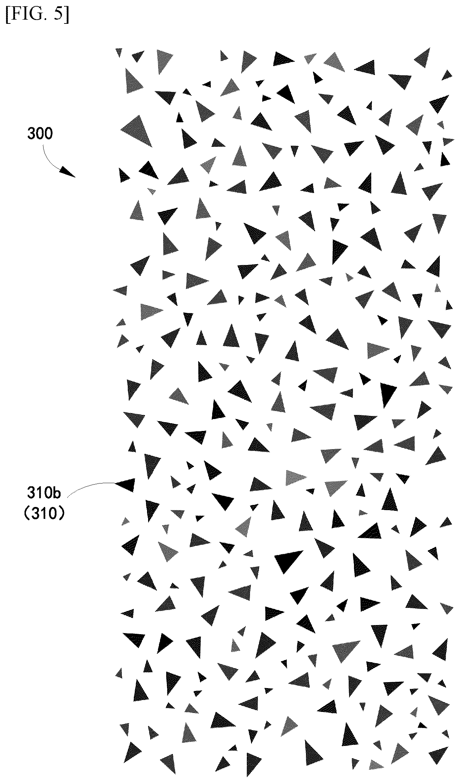

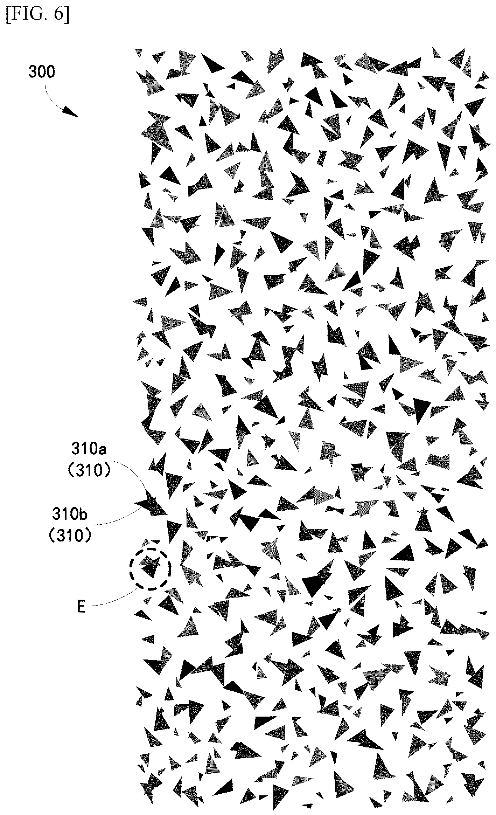

Referring to FIG. 4, FIG. 5, FIG. 6, and FIG. 7, FIG. 4 is a structure diagram of an N^{th} grating pattern 300, FIG. 5 is a structure diagram of an (N+1)^{th} grating pattern 300, and FIG. 6 is a structure diagram of an (N+1)^{th} grating pattern 300 and an N^{th} grating pattern 300 superimposed and compounded based on a preset relationship. Specifically, the grating region 310 in the N^{th} grating pattern 300 is a first grating region 310a, and the N^{th} grating pattern 300 includes a plurality of first grating regions 310a that are spaced apart. The grating region 310 in the (N+1)^{th} grating pattern 300 is a second grating region 310b, and the (N+1)^{th} grating pattern 300 includes a plurality of second grating regions 310b that are spaced apart.

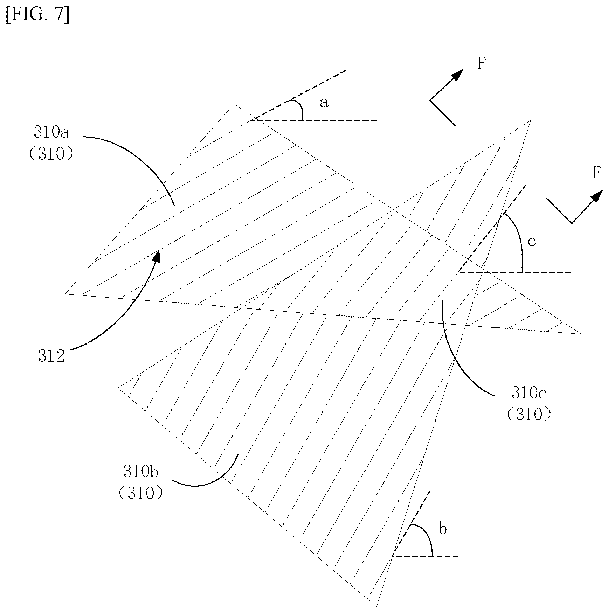

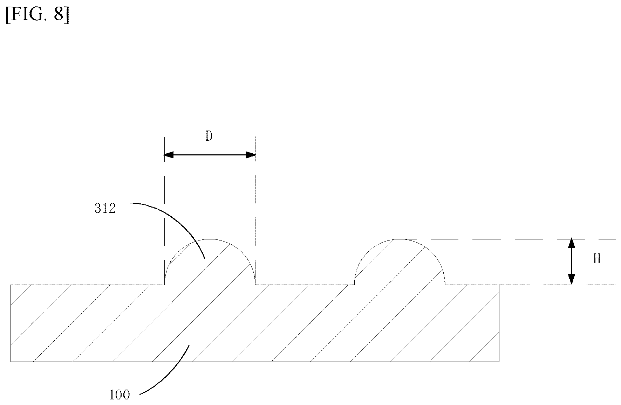

Referring to FIG. 7 and FIG. 8, the grating region 310 includes a plurality of grating structures 312 that are spaced apart. The grating structure 312 may be configured as a protrusion protruding on the base 100. A grating width D of the grating structure 312 is 30 µm to 60 µm, and a grating height H of the grating structure 312 is 0.5 µm to 20 µm. In some embodiments, the grating width D of the grating structure 312 may be 30 µm, 40 µm, 50 µm, 60 µm, or the like., and the grating height H of the grating structure 312 may be 0.5 µm, 1 µm, 5 µm, 10 µm, 10 µm, 20 µm, or the like. In some embodiments, when the grating structure 312 is configured as a groove on the base 100, the grating width D of the grating structure 312 may be a width of the groove, and the grating height H of the grating structure 312 may be a depth of the groove.

In this embodiment, the grating structure 312 is configured as a linear grating structure. For example, the grating angle of the grating region 310 may be an included angle between an extension direction of the grating structure 312 and a specific reference. For example, the grating angle of the grating region 310 may be an included angle between an extension direction of the grating structure 312 and a horizontal direction or a vertical direction. For another example, the grating angle of the grating region 310 may be an included angle between an extension direction of the grating structure 312 and an extension direction of one edge of the base 100. For example, the base 100 may have a rectangular shape, and the grating angle of the grating region 310 may be an included angle between an extension direction of the grating structure 312 and an extension direction of one of four edges of the base 100. The grating angle of the grating region 310 may be 0° to 180°, so that the grating angle of the grating region 310 in the grating layer 200 is more diversified, thereby enriching the light and shadow effect of the decorative member 10, and also allowing the light and shadow effect of the decorative member 10 under a large viewing angle to exhibit spatial hierarchy and three-dimensionality. It can be understood that the grating angles of the grating regions 310 have similar or identical light and shadow effects when ranging from 180° to 360° and ranging from 0° to 180°. In some embodiments, the grating angle of the grating region 310 may be set to a smaller range, so that the decorative member 10 has a better light and shadow effect within a specific angle range. For example, the grating angle of the grating region 310 may be 0° to 90°, 30° to 120°, or the like. In this embodiment, some structure 312 further can be configured as a curve grating structure, a broken line type grating structure, or the like.

In this embodiment, grating angles of at least two grating regions 310 in each M grating pattern 300 are different. Specifically, grating angles of at least two first grating regions 310a in a plurality of first grating regions 310a are different, and grating angles b of at least two second grating regions 310b in a plurality of second grating regions 310b are different. In some embodiments, grating angles of a plurality of grating regions 310 in each grating pattern 300 are the same.

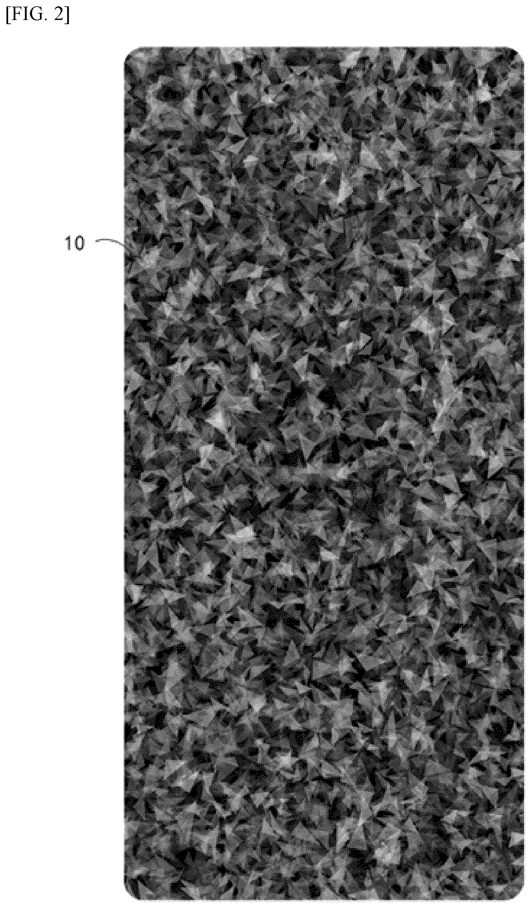

Referring to FIG. 2 and FIG. 7, the (N+1)^{th} grating pattern 300 is superimposed on the N^{th} grating pattern 300. The second grating region 310b and the first grating region 310a are superimposed to form a superimposed region 310c. The grating angle a of the first grating region 310a, the grating angle b of the second grating region 310b and the grating angle c of the superimposed region 310c satisfy a preset relationship: c=X*a+Y*b. It can be understood that because the grating angles of the grating regions 310 located at different positions in the grating layer 200 are different, brightness degrees of different grating regions 310 are different at different viewing angles. There are light and dark concentrated regions on the decorative member 10, so that a light and shadow effect of the decorative member 10 exhibits spatial hierarchy and three-dimensionality. In addition, in this application, the grating layer 200 is formed by superimposing and compounding M grating patterns 300, so that the decorative member 10 in this application can achieve a light and shadow effect with multi-layer texture superposition through a single grating layer 200, and the preparation process of the decorative member 10 is simple without a complicated texture bonding process.

In this embodiment, the grating angle a of the grating region 310 in the N^{th} grating pattern 300 and the grating angle b of the grating region 310 in the (N+1)^{th} grating pattern 300 are different, and the first weight and the second weight satisfy: 0.8≤X+Y≤1, so that the grating angle a of the first grating region 310a, the grating angle b of the second grating region 310b and the grating angle c of the superimposed region 310c are different from one another, and the decorative member 10 has more diversified light and shadow effect. In some embodiments, when the grating angle a of the grating region 310 in the N^{th} grating pattern 300 and the grating angle b of the grating region 310 in the (N+1)^{th} grating pattern 300 are the same, the first weight and the second weight satisfy: 0.8≤X+Y≤1, so that the grating angle c of the superimposed region 310c is different from the grating angle a of the first grating region 310a and the grating angle b of the second grating region 310b.

For example, in this embodiment, in at least a part of the first texture regions 210, the second weight is greater than or equal to the first weight. For example, the first weight may be 0.3, and the second weight may be 0.7, so that the grating angle c of the superimposed region 310c in the grating layer 200 is closer to the grating angle b of the second grating region 310b, a texture effect of the grating pattern 300 away from the base 100 in the grating layer 200 is more obvious, and a progressive depth-of-field effect is formed. Therefore, the spatial hierarchy of the decorative member 10 is enhanced. In some embodiments, the first weight and the second weight may both be 0.5, so that the light and shadow effect of the decorative member 10 is more uniform while the spatial hierarchy of the decorative member 10 is improved. In some embodiments, specific values of the first weight and the second weight may be specifically set according to actual needs of the decorative member 10, and are not specifically limited in this application. For example, the first weight may be 0.4, 0.2, 0.15, 0.1, or the like, and the second weight may be 0.6, 0.8, 0.85, 0.9, or the like.

In some embodiments, a sum of the first weight and the second weight is less than 1, and grating angles of two adjacent grating regions 310 are different, or grating angles of the grating region 310 and the superimposed region 310c adjacent to each other are different, so that each area of the decorative member 10 alternately flashes under different viewing angles while the decorative member 10 exhibits a sense of stacking and space, so that the decorative member 10 has a richer and more diversified light and shadow effect.

In some embodiments, a grating height H of the superimposed region 310c is greater than or equal to that of the grating region 310; and/or a grating width D of the superimposed region 310c is greater than or equal to that of the grating region 310. The grating height H is a height of the grating structure 312, and the grating width D is a width of the grating structure 312. For example, the grating height H of the superimposed region 310c may be greater than or equal to the grating height H of the first grating region 310a or the second grating region 310b. For another example, the grating width D of the superimposed region 310c may be greater than or equal to the grating width D of the first grating region 310a or the second grating region 310b. For another example, the grating height H and the grating width D of the superimposed region 310c may be greater than or equal to the grating height H and the grating width D of the first grating region 310a or the second grating region 310b respectively. In this way, the superimposed region 310c has brighter light and shadow effect relative to the first grating region 310a or the second grating region 310b, so that the decorative member 10 exhibits better spatial hierarchy.

In some embodiments, each grating region 310 in each grating pattern 300 is superimposed with at least one grating region 310 in at least one of other grating patterns 300, that is, all the grating regions 310 in the grating layer 200 are superimposed with other grating regions 310, so that the distribution of the overall light and shadow effect of the decorative member 10 is more uniform and the spatial hierarchy is better. In some embodiments, in the grating layer 200, at least a part of the grating region 310 and other grating regions 310 are spaced apart.

In some embodiments, the base 100 includes a texture surface 101 disposed facing the grating layer 200, the grating layer 200 is formed on the texture surface 101, and the grating region 310 and the superimposed region 310c completely cover the texture surface 101, that is, any point on the texture surface 101 is located in the grating region 310 or the superimposed region 310c, so that the decorative member 10 has better light and shadow effect. In some embodiments, the texture surface 101 may be partially located outside the grating region 310 or the superimposed region 310c.

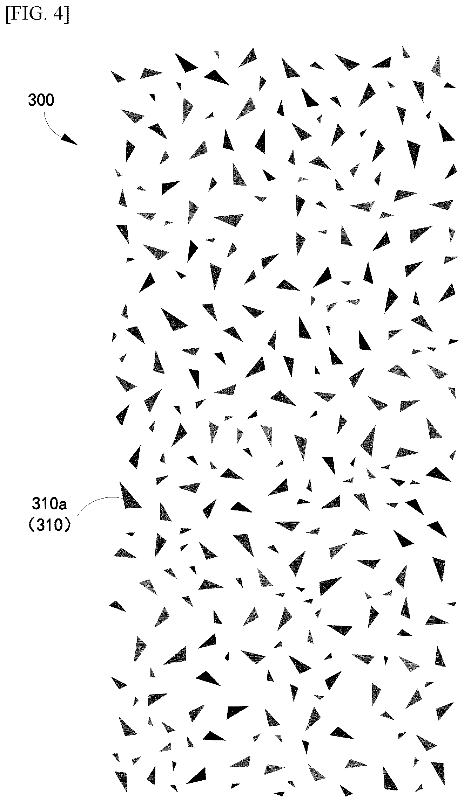

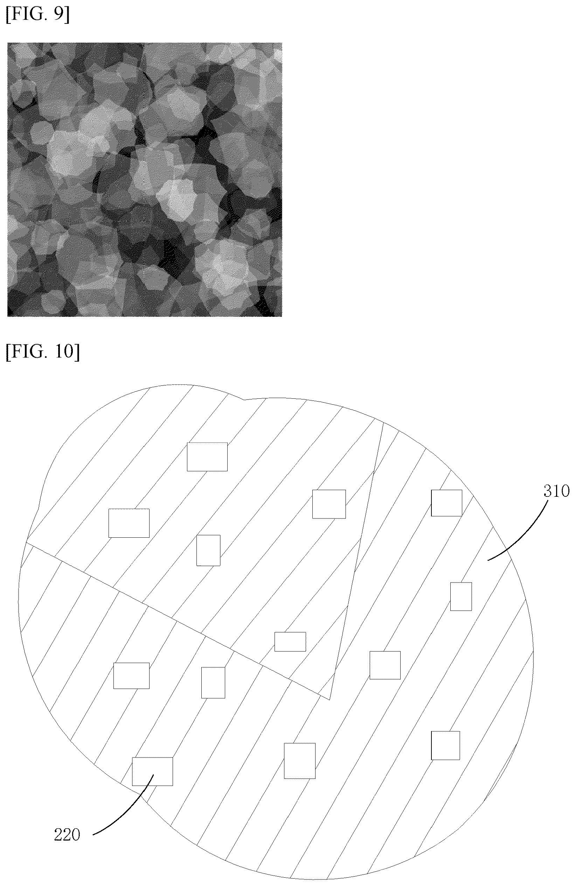

In some embodiments, shapes of a plurality of grating regions 310 in each grating pattern 300 are similar figures, and shapes of a plurality of grating regions 310 in different grating patterns 300 are similar figures. Similar figures mean that numbers of sides of the grating regions 310 are the same. Side lengths and inner angles of similar figures may be different. For example, as shown in FIG. 4, in the N^{th} grating pattern 300, the plurality of grating regions 310 have similar shapes, that is, the plurality of grating regions 310 are all triangular, but side lengths or inner angles of different grating regions 310 may be different. A shape of the grating region 310 may be a triangle, a rectangle, a pentagon, a regular polygon, an irregular polygon, a circle, an ellipse, or other special shapes. Referring to FIG. 9, in some embodiments, a shape of the grating region 310 may also be an irregular shape. For example, some edges of the grating region 310 are straight lines, and some edges are arcs.

In some embodiments, shapes of a plurality of grating regions 310 in each grating pattern 300 are similar figures, and shapes of a plurality of grating regions 310 in at least one grating pattern 300 and shapes of a plurality of grating regions 310 in other grating patterns 300 are dissimilar figures. The dissimilar figures mean that numbers of sides of the grating regions 310 are different. For example, a triangle and a rectangle are dissimilar figures. For example, shapes of the plurality of grating regions 310 in a part of the M grating patterns 300 may be triangles, and shapes of the plurality of grating regions 310 in another part of grating patterns 300 may be rectangles.

In some embodiments, in a plurality of grating regions 310 in at least one grating pattern 300, a shape of at least one grating region 310 and shapes of other grating regions 310 are dissimilar figures. For example, shapes of a plurality of grating regions 310 in one grating pattern 300 of M grating patterns 300 may include triangles and rectangles.

Referring to FIG. 10, in some embodiments, the grating layer 200 further includes a plurality of second texture regions 220 arranged in a scattered manner on the base 100. The plurality of second texture regions 220 are disposed adjacent to the first texture region 210, and/or the plurality of second texture regions 220 are embedded in the first texture region 210. The plurality of second texture regions 220 may be regularly distributed or randomly distributed on the base 100. For example, the plurality of second texture regions 220 may be distributed in an array on the base 100. In some embodiments, heights of at least two second texture regions 220 in the plurality of second texture regions 220 are different, so that the decorative member 10 has a light and shadow effect with a frosted texture. For example, the second texture region 220 may be configured as a protrusion protruding on the base 100 or a groove formed in the base 100. In some embodiments, an area of the second texture regions 220 is smaller than that of the grating region 310. The grating structure 312 is arranged in the second texture region 220, and the grating angles of the plurality of second texture regions 220 are randomly set, so that the decorative member 10 has a light and shadow effect with a sparkling sand texture. In some embodiments, heights of at least two second texture regions 220 in the plurality of second texture regions 220 are different, and an area of the second texture regions 220 is smaller than that of the grating region 310, so that the decorative member 10 has a light and shadow effect with a frosted texture and a sparkling sand texture. For example, the second texture region 220 may be configured as a protrusion protruding on the base 100. An area of an end face of the protrusion away from the base 100 is smaller than that of the grating region 310, and a grating structure 312 is arranged on the end face of the protrusion away from the base 100. Grating angles of the plurality of second texture regions 220 are randomly set.

The base 100 may be configured as a plate-like structure, a curved surface-like structure, other regular or irregular structures, and the like. For example, in this embodiment, the base 100 is configured as a plate-like structure. The base 100 includes a flat and continuous surface. The flat and continuous surface may be a planar and/or curved surface. The grating layer 200 is formed on a flat and continuous surface of the base 100, thereby facilitating processing and forming of the grating layer 200. The base 100 may be configured as, but is not limited to, a polycarbonate (polycarbonate, PC film) sheet, a polyethylene terephthalate (polyethylene terephthalate, PET) sheet, a glass sheet, a composite sheet, a ceramic sheet, a metal sheet, and the like. Composite sheets include, but are not limited to, PC composite sheets, glass fiber composite sheets or other polymer composite sheets, and the like. The PC composite sheet is, for example, a polycarbonate/polymethyl methacrylate (polycarbonate+polymethyl methacrylate, PC/PMMA) composite sheet. The base 100 may be made of a transparent material having a refractive index. In some embodiments, the base 100 may also be made of a non-transparent material, which is not specifically limited in this application.

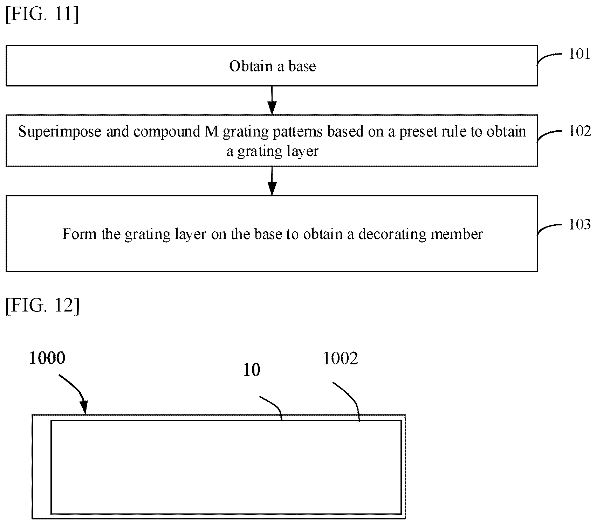

Referring to FIG. 11, FIG. 11 is a flow chart of a preparation method for a decorative member 10 according to some embodiments of this application. A preparation method for a decorative member 10 includes:
Step 101: obtain a base.
Step 102: superimpose and compound M grating patterns based on a preset relationship to obtain a grating layer.

Each grating pattern 300 includes a plurality of grating regions 310 that are spaced apart. Grating angles of the grating regions 310 on at least two grating patterns 300 in the M grating patterns 300 are different.

At least one grating region 310 in an (N+1)^{th} grating pattern 300 and at least one grating region 310 in an N^{th} grating pattern are superimposed, and a grating angle a of the grating region 310 in the N^{th} grating pattern 300, a grating angle b of the grating region 310 in the (N+1)^{th} grating pattern 300, and a grating angle c of a superimposed region 310c of the grating region 310 in the (N+1)^{th} grating pattern 300 and the grating region 310 in the N^{th} grating pattern 300 satisfy a preset relational expression: c=X*a+Y*b. N and M are integers, and 1≤N≤M-2. X is denoted as a first weight, and Y is denoted as a second weight. When the grating angle a of the grating region 310 in the N^{th} grating pattern 300 is different from the grating angle b of the grating region 310 in the (N+1)^{th} grating pattern 300, the first weight and the second weight satisfy: 0.8≤X+Y≤1. In some embodiment, when the grating angle a of the grating region 310 in the N^{th} grating pattern 300 is different from the grating angle b of the grating region 310 in the (N+1)^{th} grating pattern 300, the first weight and the second weight satisfy: 0.8≤X+Y≤1.

Step 103: form the grating layer on the base to obtain the decorative member.

In some embodiments, in at least a part of the first texture regions 210, the second weight is greater than or equal to the first weight. For example, the first weight may be 0.3, and the second weight may be 0.7, so that the grating angle c of the superimposed region 310c in the grating layer 200 is closer to the grating angle b of the second grating region 310b, a texture effect of the grating pattern 300 away from the base 100 in the grating layer 200 is more obvious, and a progressive depth-of-field effect is formed. Therefore, the spatial hierarchy of the decorative member 10 is more obvious. In some embodiments, the first weight and the second weight may both be 0.5, so that the light and shadow effect of the decorative member 10 is more uniform while the spatial hierarchy of the decorative member 10 is improved.

An embodiment of this application further provides a housing. The housing includes a base plate and the decorative member 10 in any one of the foregoing embodiments. The decorative member 10 is arranged on at least a part of a surface of the base plate. For example, the decorative member 10 is arranged on an inner surface of the housing. For another example, the housing may include a pattern area and a decorative area, and the decorative member 10 is arranged in the decorative area. A shape of the pattern region may be one of a circle, a triangle, a rectangle, a trapezoid, a polygon, or a combination of a plurality of patterns to form a special figure or pattern. The housing has a same beneficial effect as the decorative member 10 in the above embodiment, and details are not described herein again. The housing may be a mobile phone housing, a tablet computer housing, a notebook computer housing, a watch housing, a water cup housing, a remote controller housing, a box housing, an outer cover protective shell of an electronic device, or the like. The housing may be a plastic housing, a glass housing, a metal housing, or the like. In some embodiments, the grating layer 200 may be directly transferred to the base plate through a mold, that is, the base plate of the housing serves as the base 100 of the grating layer 200.

As shown in FIG. 12, an embodiment of this application further provides an electronic device 1000. The electronic device may be, for example, an electronic device such as a tablet computer, a mobile phone, a watch, an electronic reader, a remote controller, a personal computer (Personal Computer, PC), a notebook computer, a personal digital assistant (digital assistant, PDA), an in-vehicle device, a network television, a wearable device, or a television. The electronic device includes the above decorative member, so that the electronic device has a colorful and gorgeous appearance. The electronic device 1000 includes a device body 1002 and the above decorative member 10. The decorative member 10 covers at least a part of the device body 1002.

In combination with the decorative member 10 according to an embodiment of this application, the following describes a manufacturing method for the decorative member 10. In some embodiments, the manufacturing method for the decorative member 10 includes: designing, superimposing and compounding M layers of grating patterns 300 based on a preset relationship by computer software to generate texture data of a grating layer 200; according to the texture data, preparing a master mold through gray exposure, developing and drying, anti-adhesion and other processes; preparing a PC mold by a UV glue transfer process with a mold replicator according to the master mold; copying the grating layer 200 onto the PET sheet by a UV glue transfer process with a UV transfer machine according to the PC mold to form a PET sheet with the grating layer 200; coating and coloring the PET sheet; according to product appearance requirements, using laser cutting equipment or numerical control cutting equipment to cut a PET sheet with a specific shape; and bonding the cut PET sheet to a glass housing or a transparent injection molded PC housing by a bonding process.

In some embodiments, the manufacturing method for the decorative member 10 includes: designing, superimposing and compounding M layers of grating patterns 300 based on a preset relationship by computer software to generate texture data of a grating layer 200; according to the texture data, preparing a master mold through gray exposure, developing and drying, anti-adhesion and other processes; preparing a PC mold by a UV glue transfer process with a mold replicator according to the master mold; copying the grating layer onto a PC/PMMA composite sheet by a UV glue transfer process with a UV transfer machine according to a PC mold to form a PC/PMMA composite sheet with a grating layer 200; coating and coloring the PC/PMMA composite sheet; according to product appearance requirements, using laser cutting equipment or numerical control cutting equipment to cut a PC/PMMA composite sheet with a specific shape; and bonding the cut PETPC/PMMA composite sheet to a glass housing or a transparent injection molded PC housing by a bonding process.

In some embodiments, the manufacturing method for the decorative member 10 includes: designing, superimposing and compounding M layers of grating patterns 300 based on a preset relationship by computer software to generate texture data of a grating layer 200; according to the texture data, preparing a master mold through gray exposure, developing and drying, anti-adhesion and other processes; preparing a GDM mold by a UV glue transfer process with a mold replicator according to the master mold; and copying the grating layer 200 onto the glass housing by the transfer process with the GDM mold to obtain a glass housing with the grating layer 200.

In some embodiments, the manufacturing method for the decorative member 10 includes: designing, superimposing and compounding M layers of grating patterns 300 based on a preset relationship by computer software to generate texture data of a grating layer 200; uniformly coating a photoresist on the glass base, and curing the photoresist through gray exposure, developing and other processes according to the texture data; and putting the glass base into an etching bath filled with chemicals to obtain a glass base with the grating layer 200, wherein due to a protective effect of the photoresist on the glass base, etching of a thinner part of the photoresist on the glass base by chemicals is previous to etching of a thicker part of the photoresist by chemicals. Therefore, a surface of the glass base forms an uneven texture structure, that is, the grating layer 200 is formed.

In the foregoing embodiments, the description of each embodiment has respective focuses. For a part that is not described in detail in an embodiment, reference may be made to related descriptions in other embodiments.

The foregoing descriptions are merely specific embodiments of this application, but are not intended to limit the protection scope of this application. Any equivalent modifications or replacements readily figured out by a person skilled in the art within the technical scope disclosed in this application shall fall within the protection scope of this application. Therefore, the protection scope of this application shall be subject to the protection scope of the claims.

## Claims

1. A decorative member (10), comprising:
a base (100) and a grating layer (200) arranged on the base (100), wherein the grating layer (200) comprises a plurality of first texture regions (210), at least a part of the plurality of first texture regions (210) are formed by superimposing and compounding M grating patterns (300) based on a preset relationship, each grating pattern (300) comprises a plurality of grating regions (310) that are spaced apart, and grating angles of the grating regions (310) on at least two grating patterns (300) in the M grating patterns (300) are different, wherein
at least one grating region (310) in an (N+1)^{th} grating pattern (300) and at least one grating region (310) in an N^{th} grating pattern (300) are superimposed, and a grating angle a of the grating region (310) in the N^{th} grating pattern (300), a grating angle b of the grating region (310) in the (N+1)^{th} grating pattern (300), and a grating angle c of a superimposed region (310c) of the grating region (310) in the (N+1)^{th} grating pattern (300) and the grating region (310) in the N^{th} grating pattern (300) satisfy a preset relational expression: c=X*a+Y*b; and
N and M are integers, and 1≤N≤M-2; X is denoted as a first weight, and Y is denoted as a second weight; when the grating angle a of the grating region (310) in the N^{th} grating pattern (300) is different from the grating angle b of the grating region (310) in the (N+1)^{th} grating pattern (300), the first weight and the second weight satisfy: 0.8≤X+Y≤1.

2. The decorative member (10) according to claim 1, wherein when the grating angle a of the grating region (310) in the N^{th} grating pattern (300) is the same as the grating angle b of the grating region (310) in the (N+1)^{th} grating pattern (300), the first weight and the second weight satisfy: 0.8≤X+Y<1.

3. The decorative member (10) according to claim 1 or 2, wherein in at least a part of the first texture regions (210), the second weight is greater than or equal to the first weight.

4. The decorative member (10) according to any one of claims 1 to 3, wherein in at least a part of the first texture regions (210), the first weight is 0.3, and the second weight is 0.7, or both the first weight and the second weight are 0.5.

5. The decorative member (10) according to any one of claims 1 to 4, wherein the grating angles of the plurality of grating regions (310) in each grating pattern (300) are the same; or the grating angles of at least two grating regions (310) in each grating pattern (300) are different.

6. The decorative member (10) according to any one of claims 1 to 5, wherein shapes of the plurality of grating regions (310) in each grating pattern (300) are similar figures, and shapes of the plurality of grating regions (310) in different grating patterns (300) are similar figures, or shapes of the plurality of grating regions (310) in at least one grating pattern (300) and the plurality of grating regions (310) in other grating patterns (300) are dissimilar figures.

7. The decorative member (10) according to any one of claims 1 to 5, wherein in a plurality of grating regions (310) in at least one grating pattern (300), a shape of at least one grating region (310) and shapes of other grating regions (310) are dissimilar figures.

8. The decorative member (10) according to any one of claims 1 to 7, further comprising at least one of the following:
a plurality of second texture regions are arranged in a scattered manner on the base (100), wherein the second texture region is disposed adjacent to the first texture region (210); or
the second texture region is embedded in the first texture region (210); or
heights of at least two second texture regions of the second texture regions are different; or
an area of the second texture regions is less than that of the grating region (310).

9. The decorative member (10) according to any one of claims 1 to 8, wherein each grating region (310) in each grating pattern (300) and at least one grating region (310) in at least one of other grating patterns (300) are superposed.

10. The decorative member (10) according to any one of claims 1 to 9, wherein the base (100) comprises a texture surface disposed facing the grating layer (200), the grating layer (200) is formed on the texture surface, and the grating region (310) and the superimposed region (310c) completely cover the texture surface.

11. The decorative member (10) according to any one of claims 1 to 10, wherein the grating region (310) comprises a plurality of grating structures (312) that are spaced apart, and the grating structure (312) has a width of 30 µm to 60 µm and a height of 0.5 µm to 20 µm.

12. The decorative member (10) according to any one of claims 1 to 11, wherein a grating height of the superimposed region (310c) is greater than or equal to that of the grating region (310); and/or a grating width of the superimposed region (310c) is greater than or equal to that of the grating region (310).

13. The decorative member (10) according to any one of claims 1 to 12, wherein a sum of the first weight and the second weight is less than 1, and grating angles of two adjacent grating regions (310) are different, or grating angles of the grating region (310) and the superimposed region (310c) adjacent to each other are different.

14. An electronic device (1000), comprising a device body (1002) and the decorative member (10) according to any one of claims 1 to 12, wherein the decorative member (10) covers at least a part of the device body (1002).

15. A preparation method for a decorative member (10), comprising:
obtaining a base (100);
superimposing and compounding M grating patterns (300) based on a preset relationship to obtain a grating layer (200), wherein
each grating pattern (300) comprises a plurality of grating regions (310), and grating angles of the grating regions (310) on at least two grating patterns (300) in the M grating patterns (300) are different; at least one grating region (310) in the (N+1)^{th} grating pattern (300) and at least one grating region (310) in an N^{th} grating pattern (300) are superimposed, and a grating angle a of the grating region (310) in the N^{th} grating pattern (300), a grating angle b of the grating region (310) in the (N+1)^{th} grating pattern (300), and a grating angle c of a superimposed region (310c) of the grating region (310) in the (N+1)^{th} grating pattern (300) and the grating region (310) in the N^{th} grating pattern (300) satisfy a preset relational expression: c=X*a+Y*b; N and M are integers, and 1≤N≤M-2; X is denoted as a first weight, and Y is denoted as a second weight; when the grating angle a of the grating region (310) in the N^{th} grating pattern (300) is different from the grating angle b of the grating region (310) in the (N+1)^{th} grating pattern (300), the first weight and the second weight satisfy: 0.8≤X+Y≤1; and
forming the grating layer (200) on the base (100) to obtain the decorative member (10).
